# EUROPEAN PATENT SPECIFICATION

(11) **EP 3 958 325 B1**
(45) Date of publication and mention of the grant of the patent: **25.06.2025**
(21) Application number: 20191517.0
(22) Date of filing: 18.08.2020
(51) Int. Cl.: H10D 30/66, H10D 62/10

(54) **SEMICONDUCTOR DEVICE**
HALBLEITERBAUELEMENT
DISPOSITIF À SEMICONDUCTEUR

(43) Date of publication of application: 23.02.2022
(73) Proprietor: Infineon Technologies Austria AG, 9500 Villach (AT)
(72) Inventor: FACHMANN, Christian, 9586 Fürnitz (AT); RIEGLER, Andreas, 9241 Lichtpold (AT)
(74) Representative: Westphal, Mussgnug & Partner, Patentanwälte mbB

(56) References cited:
- US-A- 6 060 744
- US-A1- 2006 289 915
- US-A1- 2011 198 587
- US-A1- 2012 193 702
- US-A1- 2019 393 334

## Description

### TECHNICAL FIELD

The instant disclosure relates to a semiconductor device, in particular to an arrangement comprising a transistor device and a current detection element.

### BACKGROUND

Semiconductor devices such as insulated gate power transistor devices, e.g., power MOSFETs (Metal Oxide Semiconductor Field-Effect Transistors) or IGBTs (Insulated Gate Bipolar Transistors), are widely used as electronic switches in various types of electronic applications. In many applications such as high current applications, for example, a current through the semiconductor device is measured. Such current measurements are often performed by determining a voltage over an external shunt resistor. Such an external resistance, however, adds to the overall losses of the arrangement and may reduce the efficiency.

Document US 2006/289915 A1 discloses a semiconductor device comprising a semiconductor portion including first semiconductor layers of a first conduction type and second semiconductor layers of a second conduction type alternately arranged on the surface of a semiconductor substrate to form a striped shape. A main region is formed to arrange a main cell in a well. A current sense cell is arranged in a sense well. A sense region is formed having the direction of the length in a direction that intersects the direction of alternate arrangement of the first semiconductor layers and the second semiconductor layers.

Document US 2011/198587 A1 discloses a semiconductor apparatus including a power MOSFET including a main MOSFET and sensing MOSFET's. The main MOSFET and the sensing MOSFET's are formed on a semiconductor substrate, and a sensing MOSFET is selected for changing the sensing ratio and further for confining the sensing ratio variations within a certain narrow range stably from a low main current range to a high main current range.

Document US 6 060 744 A discloses a current detecting cell of a MOS-type semiconductor device with a current detection function, wherein the area of the contact portions of source regions which contact a current detecting electrode is greater than that of that contact portion of a base region which contacts the current detecting electrode.

Document US 2019/393334 A1 discloses a method including partly removing a supporting layer arranged between a first semiconductor layer and a second semiconductor layer using an etching process to form at least one undercut between the first semiconductor layer and the second semiconductor layer, at least partly filling the at least one undercut with a first material having a higher thermal conductivity than the supporting layer, and forming a sensor device in or on the second semiconductor layer.

It is desirable to provide a semiconductor device comprising a current detection element that has low losses and may be operated effectively.

### SUMMARY

One example relates to a semiconductor device. The semiconductor device includes a semiconductor body including a first surface, a second surface opposite to the first surface in a vertical direction, an active region, and a sensor region arranged adjacent to the active region in a first horizontal direction. The semiconductor device further includes a plurality of transistor cells at least partly integrated in the active region, each transistor cell including a source region, a body region, a drift region separated from the source region by the body region, and a gate electrode dielectrically insulated from the body region. The semiconductor device further includes at least one sensor cell at least partly integrated in the sensor region, each of the at least one sensor cell comprising a source region, a body region, a drift region separated from the source region by the body region, and a gate electrode dielectrically insulated from the body region. The semiconductor device further includes a plurality of first contact plugs, an intermediate layer, and a second contact plug. The source regions of the plurality of transistor cells are coupled to a first source electrode, and the source regions of the at least one sensor cell are coupled to a second source electrode separate and distant from the first source electrode. At least one of the plurality of transistor cells directly adjoins one of the at least one sensor cells. Each of the plurality of first contact plugs extends between one of the source regions of the at least one sensor cell and the intermediate layer, and provides an electrical connection between the respective source region and the intermediate layer, and the second contact plug extends between the intermediate layer and the second source electrode, and provides an electrical connection between the intermediate layer and the second source electrode.

Examples are explained below with reference to the drawings. The drawings serve to illustrate certain principles, so that only aspects necessary for understanding these principles are illustrated. The drawings are not to scale. In the drawings the same reference characters denote like features.

### BRIEF DESCRIPTION OF THE DRAWINGS

Figure 1 schematically illustrates a cross sectional view of a semiconductor body.
Figure 2 schematically illustrates a cross sectional view of another semiconductor body.
Figure 3 shows an equivalent circuit diagram of a transistor device and an external current sense resistor.
Figure 4 shows an equivalent circuit diagram of a transistor device and a current detection device according to an example.
Figure 5 schematically illustrates a top view of a semiconductor arrangement according to an example.
Figure 6 schematically illustrates the minimal dimensions of a current detection device according to an example.
Figure 7 schematically illustrates a cross sectional view of a semiconductor device according to an example.

Figure 8 schematically illustrates a cross sectional view of a semiconductor device according to another example.

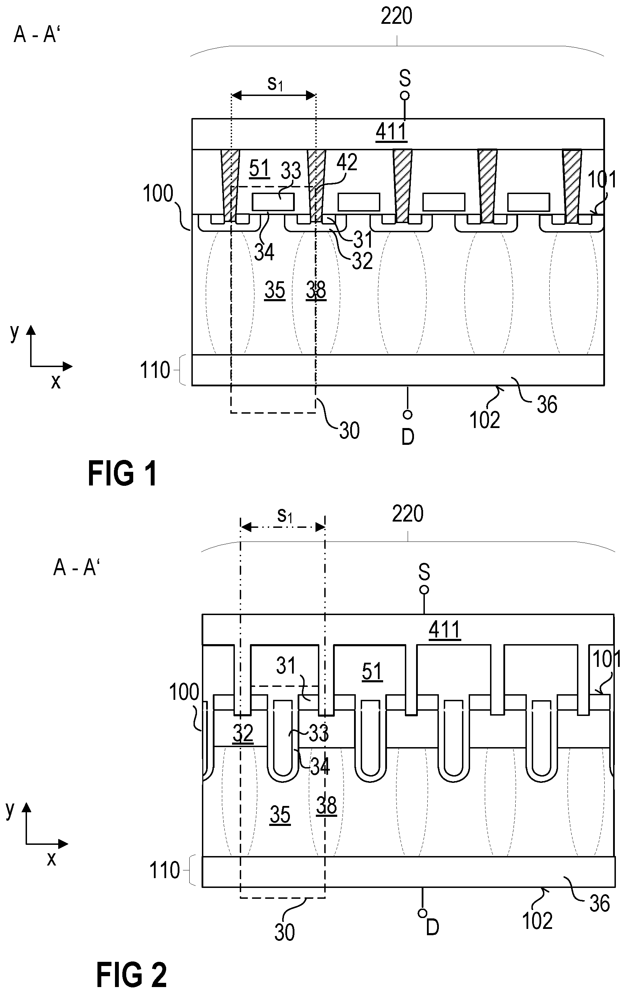

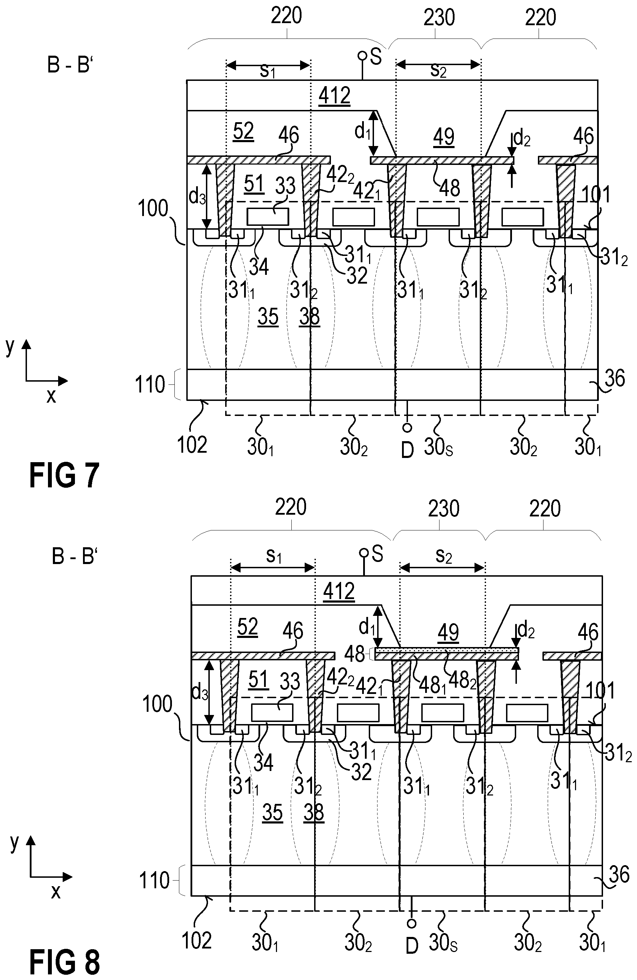

It is noted that only Figures 7 and 8 show examples falling within the scope of the present invention, while the examples of Figures 1-6 do not form part of the claimed invention but are useful to understand it.

### DETAILED DESCRIPTION

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

Referring to Figure 1, a cross-sectional view of a semiconductor device comprising a semiconductor body 100 is schematically illustrated. The semiconductor body 100 may include a conventional semiconductor material such as, for example, silicon (Si), silicon carbide (SiC), gallium nitride (GaN), gallium arsenide (GaAs), or the like. A transistor device is formed in the semiconductor body 100, the transistor device being arranged in an active region 220 of the semiconductor body 100. In Figure 1, only a small section of the transistor device is shown. In its active region 220, the semiconductor body 100 includes at least one working transistor cell 30 with a gate electrode 33 that is dielectrically insulated from a body region 32 by a gate dielectric 34. The body region 32 is a doped semiconductor region in the active region 220 of the semiconductor body 100. In the example illustrated in Figure 1, the body region 32 extends from a first surface 101 into the semiconductor body 100, and the gate electrode 33 is arranged above the first surface 101 of the semiconductor body 100. Each of the transistor cells 30 further includes at least one source region 31 extending from the first surface 101 into the body region 32.

The transistor device illustrated in Figure 1 further includes a drift region 35 formed in the semiconductor body 100. The drift region 35 adjoins the body region 32 of the at least one transistor cell 30 and forms a pn-junction with the body region 32. The drift region 35 is arranged between the body region 32 of the at least one transistor cell 30 and a semiconductor layer 110. The semiconductor layer 110 is arranged between a second surface 102 of the semiconductor body 100 and the drift region 35. The second surface 102 is arranged opposite to the first surface 101 in a vertical direction y of the semiconductor body 100.

The semiconductor layer 110 comprises a drain region 36 of the same doping type as the drift region 35 and adjoining the second surface 102. Optionally, a vertical field-stop-region (not specifically illustrated in Figure 1) of the same doping type as the drift region 35 and the drain region 36, but less highly doped than the drain region 36, may be arranged between the drift region 35 and the drain region 36. That is, the semiconductor layer 110 may be formed by the drain region 36 and the adjoining vertical field-stop-region. Such a vertical field-stop-region may be formed by a single layer or by a plurality of separate sub-layers, e.g., at least two sub-layers. Sub-layers that are arranged closer to the drift region 35 may be less highly doped than sub-layers that are arranged further away from the drift region 35. For example, a doping concentration of a sub-layer that is arranged adjacent to the drift region 35 may be selected from a range of between 1E15 and 1E16 cm⁻³ or lower. A doping concentration of a sub-layer that is arranged adjacent to the drain region 36 may be higher than a doping concentration of a sub-layer that is arranged horizontally above. The doping concentration of the sub-layer that is arranged adjacent to the drain region 36, however, may be lower than a doping concentration of the drain region 36. Generally speaking, a doping concentration of the different sub-layers may increase from the drift region 35 towards the drain region 36.

Still referring to Figure 1, the transistor device includes at least one vertical compensation region 38 of a doping type complementary to the doping type of the drift region 35. According to one example, the transistor device includes a plurality of transistor cells 30 and each transistor cell 30 includes a vertical compensation region 38 adjoining the body region 32 of the respective transistor cell 30. In a vertical direction y of the semiconductor body 100, which is a direction perpendicular to the first surface 101 and to the second surface 102, the at least one vertical compensation region 38 extends from the body region 32 into the semiconductor body 100 towards the semiconductor layer 110.

Still referring to Figure 1, the transistor device further includes a first source electrode 411. The first source electrode 411 is electrically connected to the source region 31 and the body region 32 of the at least one transistor cell 30 by means of contact plugs 42. The contact plugs 42 may comprise at least one of polysilicon, tungsten, aluminum, copper, and a Ti/TiN barrier liner, for example. This first source electrode 411 forms a source node S or is electrically connected to a source node S of the transistor device. The transistor device further includes a drain node D electrically connected to the drain region 36. A drain electrode electrically connected to the drain region 36 may form the drain node D.

The transistor device can be an n-type transistor device or a p-type transistor device. The device type is defined by the doping type of the source region 31. In an n-type transistor device, the source region 31 is an n-type region, the body region 32 is a p-type region, the drift region 35, which has a doping type complementary to the doping type of the body region 32, is an n-type region, and the at least one vertical compensation region 38 is a p-type region. In a p-type transistor device, the source region 31 is a p-type region, the body region 32 is an n-type region, the drift region 35 is a p-type region, and the at least one vertical compensation region 38 is an n-type region. The transistor device can be implemented as a MOSFET, for example. In a MOSFET, the drain region 36 has the same doping type as the drift region 35, as has been described above. For example, a doping concentration of the drain region 36 is selected from a range of between 1E18 and 1E19 cm⁻³, 1E18 and 1E20 cm⁻³, or 1E18 and 1E21 cm⁻³, doping concentrations of the drift region 35 and the vertical compensation region 38 are selected from a range of between 1E15 and 5E16 cm⁻³, and a doping concentration of the body region 32 is selected from between 5E16 cm⁻³ and 5E17 cm⁻³. The transistor cells 30 illustrated in Figure 1 are planar transistor cells. Implementing the transistor cells 30 as planar transistor cells, however, is only one example. According to another example, as is illustrated in Figure 2, the transistor cells 30 are implemented as trench transistor cells. That is, the at least one gate electrode 33 is arranged in a trench that extends from the first surface 101 into the semiconductor body 100.

In the transistor device explained above, a plurality of transistor cells 30 is connected in parallel. That is, the source regions 31 of these transistor cells 30 are connected to the source node S, the common drain region 36 is connected to the drain node D, and the at least one gate electrode 33 is connected to a gate node .

The contact plugs 42 that are arranged below the first source electrode 411 extend from the source and body regions 31, 32 through an insulation layer 51 that is formed on the top surface 101 of the semiconductor body 100 to the first source electrode 411 to electrically couple the source and body regions 31, 32 to the first source electrode 411. In Figures 1 and 2, the insulation layer 51 is illustrated as a single continuous layer which extends from the first surface 101 of the semiconductor body 100 to the first source electrode 411. This, however, is only an example. Often, a gate oxide layer with a thickness of, e.g., 5nm to 200nm or 40nm to 120nm, is arranged on the first surface 101 of the semiconductor body 100. The insulation layer 51 may comprise this gate oxide layer and an additional layer which is formed on top of this gate oxide layer. This additional layer may comprise an undoped TEOS (tetraethyl orthosilicate) which may have a thickness of about 50nm to 500nm, and a doped BPSG (borophosphosilicate glass) having a thickness of about 200nm to 2µm or 1100nm to 1300nm, for example. The insulation layer 51, therefore, may comprise several sub-layers.

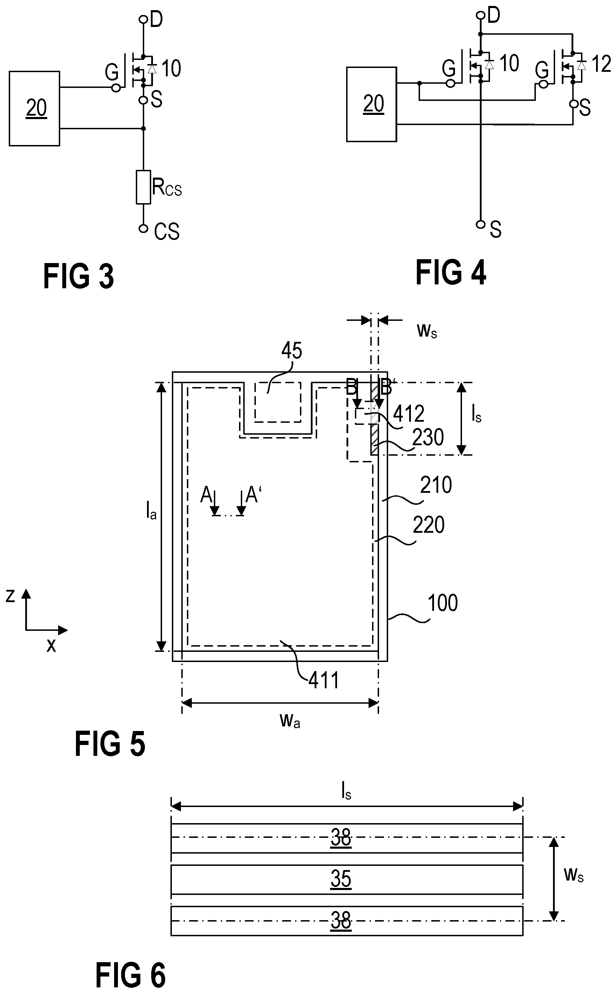

In many applications such as high current applications, for example, a current through the transistor device 10 is measured. Such current measurements are often performed by determining a voltage over an external shunt resistor Rcs, as is schematically illustrated in the circuit diagram of Figure 3. The voltage over the shunt resistor R_{CS}, and the current through the transistor device 10 may be determined by means of a controller 20, for example. Such an external shunt resistor R_{CS}, however, adds to the overall losses of the arrangement and may reduce the efficiency.

According to one example, therefore, the current through the transistor device 10 is determined by means of a current detection element 12. This is schematically illustrated in the circuit diagram of Figure 4. In this case, an external shunt resistor R_{CS} is no longer required. The current detection element 12 may be integrated in the same semiconductor body 100 as the transistor device 10, as will be described in more detail further below. The current detection element 12 may comprise an additional transistor device. A gate electrode G of the additional transistor device may be electrically coupled to a gate electrode G of the transistor device 10. The gate electrodes G of the transistor device 10 and the additional transistor device may be coupled to the controller 20. A drain electrode D of the additional transistor device may be electrically coupled to a drain electrode D of the transistor device 10. A source electrode S of the additional transistor device may be coupled to the controller 20. A source electrode S of the transistor device 10 is separate from and not electrically coupled to the source electrode of the additional transistor device.

Now referring to Figure 5, a top view of an exemplary semiconductor arrangement in a semiconductor body 100 is schematically illustrated. As has been described with respect to Figures 1 and 2 above, the transistor device is arranged in an active region 220 of the semiconductor body 100. Figures 1 and 2 illustrate exemplary cross-sectional views of a part of the transistor device along section line A - A' as indicated in Figure 5.

A semiconductor body 100 usually comprises not only an active region 220, but also an inactive region, also referred to as passive region or edge (termination) region 210. The semiconductor arrangement, that is, the plurality of transistor cells 30, may be implemented within the active region 220 of the semiconductor body 100. An edge region 210, e.g., may be a region adjacent to the horizontal edges (outer edges) of the semiconductor body 100 (edge region). The outer edges extend in the vertical direction y between the first surface 101 and the second surface 102 and are essentially perpendicular to the first surface 101 and the second surface 102. A semiconductor body 100 having a rectangular or square cross section, for example, generally comprises four outer edges. According to one example and as is schematically illustrated in Figure 5, the active region 220 is horizontally surrounded by the edge region 210. The edge region 210 generally does not comprise any working transistor cells 30. In particular, an edge region 210 may be a region that does not include all active components that are necessary to form a functioning (working) transistor cell 30. Active components are, e.g., gate oxide, source regions 31, body regions 32, gate electrodes 33, or drain regions 36. For example, the edge region 210 may be a region within the semiconductor body 100 which does not comprise any source regions 31.

The first source electrode 411 and a gate electrode 45 are arranged on the semiconductor body 100 (indicated in dashed lines in Figure 5). The first source electrode 411 may be arranged on the active region 220 of the semiconductor body 100, for example. In addition to the transistor device comprising a plurality of transistor cells 30, the semiconductor device further comprises at least one sensor cell. The at least one sensor cell may be at least partly arranged in a sensor region 230 (crosshatched area in Figure 5). The sensor region 230, therefore, may also comprise at least one working transistor cell, similar to the active region 220. In the example illustrated in Figure 5, the sensor region 230 adjoins both the active region 220 and the edge region 210. This, however, is only an example. According to another example, the sensor region 230 may be surrounded by the active region 220 on three or four sides. That is, the sensor region may adjoin the active region 220, but not the edge region 210, or may only adjoin the edge region 210 with one of its narrow sides. As will be described in further detail below, the at least one sensor cell arranged in the sensor region 230 may be electrically coupled to a second source electrode 412. The second source electrode 412 may be arranged on the same side of the semiconductor body 100 as the first source electrode 411. The second source electrode 412 may be arranged distant from the first source electrode 411 such that the first source electrode 411 and the second source electrode 412 are not electrically coupled to each other and may be contacted individually.

The semiconductor body 100 may have a rectangular form, for example. Other forms such as a square form, for example, however are also possible. The active region 210 may have a width wₐ in a first horizontal direction x, and a length lₐ in a second horizontal direction z perpendicular to the first horizontal direction x. The sensor region 230 may have a width wₛ in the first horizontal direction, and a length lₛ in the second horizontal direction z.

As is schematically illustrated in Figure 6, the width wₛ of the sensor region 230 may correspond to the width wₛ of a single sensor cell, and the length lₛ of the sensor region 230 may correspond to the length lₛ of the sensor cell. A sensor cell 30s will be described in further detail with respect to Figure 7 in the following. In the cross-sectional view of Figure 7, a plurality of transistor cells 30₁, 30₂, is schematically illustrated. The transistor cells 30₁, 30₂ essentially correspond to the transistor cells 30 that have been described with respect to Figures 1 and 2 above. The semiconductor device illustrated in Figure 7 further comprises a sensor cell 30_{S}. In the example illustrated in Figure 7, the sensor cell 30_{S} directly adjoins one of the transistor cells 30₂ on each side in the first horizontal direction x. That is, at least one working sensor cell 30_{S} of the sensor region 230 directly adjoins at least one working transistor cell 30₂ of the active region 220 without any transition zone or intermediate region arranged therebetween, a transition zone or intermediate region being a region without any working transistor cells. The sensor region 230 comprising only one sensor cell 30s, however, is only an example. The sensor region 230 may also comprise more than one sensor cell 30_{S}. Each of the at least one sensor cell 30_{S} may essentially correspond to one of the plurality of transistor cells 30₁, 30₂. That is, each of the at least one transistor cells 30_{S} comprises a gate electrode 33 that is dielectrically insulated from a body region 32 by a gate dielectric 34. In the example illustrated in Figure 7, the body region 32 extends from the first surface 101 into the semiconductor body 100, and the gate electrode 33 is arranged above the first surface 101 of the semiconductor body 100. According to another example, similar to the transistor cells 30 illustrated in Figure 2, the sensor cells 30_{S} may alternatively be implemented as trench transistor cells. That is, the at least one gate electrode 33 may be arranged in a trench that extends from the first surface 101 into the semiconductor body 100. Each of the at least one sensor cell 30s further includes at least one source region 31₁, 31₂ extending from the first surface 101 into the body region 32. The source regions of the at least one sensor cell 30_{S} are coupled to the second source electrode 412.

The sensor cell 30s illustrated in Figure 7 further includes a drift region 35 formed in the semiconductor body 100. The drift region 35 adjoins the body region 32 of the at least one sensor cell 30_{S} and forms a pn-junction with the body region 32. The drift region 35 is arranged between the body region 32 of the at least one sensor cell 30_{S} and the semiconductor layer 110. Each of the at least one sensor cell 30s further comprises a compensation region 38 of a doping type complementary to the doping type of the drift region 35 and extending from a respective body region 32 into the drift region 35 in the vertical direction y.

The gate electrodes 33 of the plurality of transistor cells 30₁, 30₂ and the gate electrodes 33 of the at least one sensor cell 30s are coupled to a common gate pad 45, and the drift regions 35 of the plurality of transistor cells 30₁, 30₂ and the drift regions 35 of the at least one sensor cell 30_{S} are coupled to a common drain region 36. As has been described with respect to Figure 5 above, the source regions 31₁, 31₂ of the at least one sensor cell 30_{S} are coupled to a second source electrode 412 that is separate and distant from the first source electrode 411.

According to one example, the plurality of transistor cells 30₁, 30₂ comprises a plurality of first transistor cells 30₁, each of the at least one first transistor cell 30₁ comprising two source regions 31₁, 31₂, and at least one but not more than two second transistor cells 30₂, each of the second transistor cells 30₁ comprising only one source region 31₁. As is exemplarily illustrated in Figure 7, each of the second transistor cells 30₂ directly adjoins one of the at least one sensor cells 30_{S} and is arranged between the at least one sensor cell 30_{S} and at least a subset of the plurality of first transistor cells 30₁. That is, each of the second transistor cells 30₂ may function as a bordering cell that is arranged between one of the first transistor cells 30₁ and an outermost of the sensor cells 30_{S}. The second transistor cells 30₂, however, are working transistor cells and only differ from the first transistor cells 30₁ in the number of source region 31₁, 31₂ per transistor cell. The single source region 31₁ of a second transistor cell 30₂ may be arranged closer to an adjoining first transistor cell 30₁ than to an adjoining sensor cell 30_{S}. That is, the second source region 31₂ may be omitted on a side of the second transistor cell 30₂ that faces the adjoining sensor cell 30s.

As has been described with respect to Figure 5 above, the sensor region 230 may be arranged between the active region 220 and the edge region 210. In this example, therefore, there may be only one second transistor cell 30₂. If, however, the sensor region 230 is surrounded by the active region 220 on both sides in the first horizontal direction x, as is exemplarily illustrated in Figure 7, there may be two second transistor cells 30₂, one on each side of the sensor region 230 in the first horizontal direction x. Such an arrangement may ensure a symmetric heating of the sensor region 230. In the examples described by means of Figures 1, 2 and 7 above, each first transistor cell 30₁ comprises two source region 31₁, 31₂. This, however, is only an example. According to another example, it is also possible that a first transistor cell 30₁ only comprises one source region 31₁. That is, there may not be any difference between the first transistor cells 30₁ and the second transistor cells 30₂.

Still referring to Figure 7, the semiconductor device and, in particular, the sensor region 230 further comprises a plurality of first contact plugs 42₁, an intermediate layer 48, and a second contact plug 49, wherein each of the plurality of first contact plugs 42₁ extends between one of the source regions 31₁, 31₂ of the at least one sensor cell 30_{S} and the intermediate layer 48, and provides an electrical connection between the respective source region 31₁, 31₂ and the intermediate layer 48. The second contact plug 49 extends between the intermediate layer 48 and the second source electrode 412, and provides an electrical connection between the intermediate layer 48 and the second source electrode 412. The plurality of first contact plugs 42₁ may be similar to the contact plugs 42₂ connecting the first source electrode 411 to the source regions 31₁, 31₂ and the body region 32 of the at least one transistor cell 30₁, 30₂. That is, the first contact plugs 42₁ may comprise at least one of polysilicon, tungsten, aluminum, copper, and a Ti/TiN barrier liner, for example. The intermediate layer 48 may comprise tungsten, for example. The second contact plug 49 may comprise the same material as the second source electrode 412 such as aluminum, for example. The first contact plugs 42₁ may be narrow contact plugs, while the second contact plug 49 may be a broad contact plug. That is, a width of a first contact plug 42₁ in the first horizontal direction x may be significantly smaller than a width of the second contact plug 49 in the first horizontal direction x.

In the example illustrated in Figure 7, the intermediate layer 48 comprises a single layer. This, however, is only an example. According to another example, and as is schematically illustrated in Figure 8, the intermediate layer 48 may comprise more than one layer. For example, the intermediate layer 48 may comprise a first sublayer 48₁ and a second sublayer 48₂ that is arranged adjacent to the first sublayer 48₁ in the vertical direction y. The first sublayer 48₁ may be arranged between the first contact plugs 42₁ and the second sublayer 48₂, and the second sublayer 48₂ may be arranged between the first sublayer 48₁ and the second contact plug 49. The first sublayer 48₁ in this example comprises a different material than the second sublayer 48₂. According to one example, the first sublayer 48₁ comprises the same material as the first contact plugs 42₁, e.g., tungsten, and the second sublayer 48₂ comprises the same material as the second contact plug 49, e.g., aluminum. Other combinations of materials, however, are also possible.

According to one example, a distance d₁ between the intermediate layer 48 and the second source electrode 412 in the vertical direction y is between 300nm and 1000nm, or between 400nm and 800nm. A thickness d₂ of the intermediate layer 48 in the vertical direction y may be between 200nm and 600nm, for example. A distance d₃ between the source regions 31₁, 31₂ and the intermediate layer 48 in the vertical direction y may be between 300nm and 1000nm, or between 400nm and 800nm, for example. Other distances and thicknesses, however, are generally also possible.

The number of transistor cells 30₁, 30₂ is generally significantly larger than the number of sensor cells 30s. According to one example, a ratio between the number of sensor cells 30_{S} and the number of transistor cells 30₁, 30₂ is between 1:10 and 1:40000. Other ratios, however, are generally also possible. According to one example, the sensor region 230 is smaller than the second source electrode 412. This may increase the accuracy of the measurements.

Further, a size of the sensor region 230 may be significantly smaller than a size of the active region. According to one example and as is schematically illustrated in Figures 5 and 7, each of the plurality of transistor cells 30₁, 30₂ has a first length lₐ in the second horizontal direction z, and a first width s₁ in the first horizontal direction x. Each of the at least one sensor cell 30_{S} has a second length lₛ in the second horizontal direction z, and a second width s₂ in the first horizontal direction x. The first length lₐ may be at least three times the second length lₛ. The first width s₁ may equal the second width s₂. However, as the number of transistor cells 30₁, 30₂ is generally larger than the number of sensor cells 30_{S}, an overall width wₐ of the active region 220 is generally larger than an overall width wₛ of the sensor region 230. There may be a certain number of transistor cells 30₁, 30₂, however, that have a length in the second horizontal direction z that is shorter than the first length lₐ. Such transistor cells 30₁, 30₂ may be arranged adjacent to the sensor region 230 in the second horizontal direction z. The length of such transistor cells 30₁, 30₂ may be shorter in order to allow integration of the sensor region 230 in the semiconductor body 100.

The second source electrode 412 may have a thickness in the vertical direction y of between 2 and 10µm, or between 3 to 5 µm, for example. A width of the second source electrode 412 in the first horizontal direction x may be between 20 and 30µm, for example, and a length of the second source electrode 412 in the second horizontal direction z may be between 20 and 30µm, for example.

## Claims

1. A semiconductor device, comprising:
a semiconductor body (100) comprising a first surface (101), a second surface (102) opposite to the first surface (101) in a vertical direction (y), an active region (220), and a sensor region (230) arranged adjacent to the active region (220) in a first horizontal direction (x);
a plurality of transistor cells (30₁, 30₂) at least partly integrated in the active region (220), each transistor cell (30₁, 30₂) comprising a source region (31), a body region (32), a drift region (35) separated from the source region (31) by the body region (32), and a gate electrode (33) dielectrically insulated from the body region (32);
at least one sensor cell (30_{S}) at least partly integrated in the sensor region (230), each of the at least one sensor cell (30_{S}) comprising a source region (31), a body region (32), a drift region (35) separated from the source region (31) by the body region (32), and a gate electrode (33) dielectrically insulated from the body region (32);
a plurality of first contact plugs (42₁);
an intermediate layer (48); and
a second contact plug (49), wherein
the source regions (31) of the plurality of transistor cells (30₁, 30₂) are coupled to a first source electrode (411), and the source regions (31) of the at least one sensor cell (30_{S}) are coupled to a second source electrode (412) separate and distant from the first source electrode (411),
at least one of the plurality of transistor cells (30₁, 30₂) directly adjoins one of the at least one sensor cells (30s),
each of the plurality of first contact plugs (42₁) extends between one of the source regions (31) of the at least one sensor cell (30_{S}) and the intermediate layer (48), and provides an electrical connection between the respective source region (31) and the intermediate layer (48), and
the second contact plug (49) extends between the intermediate layer (48) and the second source electrode (412), and provides an electrical connection between the intermediate layer (48) and the second source electrode (412).

2. The semiconductor device of claim 1, wherein
each of the plurality of transistor cells (30₁, 30₂) further comprises a compensation region (38) of a doping type complementary to the doping type of the drift region (35) and extending from a respective body region (32) into the drift region (35) in the vertical direction (y); and
each of the at least one sensor cell (30_{S}) further comprises a compensation region (38) of a doping type complementary to the doping type of the drift region (35) and extending from a respective body region (32) into the drift region (35) in the vertical direction (y).

3. The semiconductor device of claim 1 or 2, wherein
the gate electrodes (33) of the plurality of transistor cells (30₁, 30₂) and the gate electrodes (33) of the at least one sensor cell (30_{S}) are coupled to a common gate pad (45), and
the drift regions (35) of the plurality of transistor cells (30₁, 30₂) and the drift regions (35) of the at least one sensor cell (30_{S}) are coupled to a common drain region (36).

4. The semiconductor device of any of claims 1 to 3, wherein the plurality of transistor cells (30₁, 30₂) comprises
a plurality of first transistor cells (30₁), each of the at least one first transistor cell (30₁) comprising two source regions (31₁, 31₂);
and at least one but not more than two second transistor cells (30₂), each of the second transistor cells (30₁) comprising only one source region (31₁), wherein
each of the second transistor cells (30₂) directly adjoins one of the at least one sensor cells (30s) and is arranged between the at least one sensor cell (30s) and at least a subset of the plurality of first transistor cells (30₁).

5. The semiconductor device of any of claims 1 to 4, wherein the intermediate layer (48) comprises tungsten.

6. The semiconductor device of any of claims 1 to 5, wherein
the intermediate layer (48) comprises a first sublayer (48₁) and a second sublayer (48₂) arranged adjacent to the first sublayer (48₁) in the vertical direction (y); and
the first sublayer (48₁) comprises a different material than the second sublayer (48₂).

7. The semiconductor device of claim 6, wherein the first sublayer (48₁) comprises tungsten and the second sublayer (48₂) comprises aluminum.

8. The semiconductor device of any of claims 1 to 7, wherein a distance (d₁) between the intermediate layer (48) and the second source electrode (412) in the vertical direction (y) is between 300nm and 1000nm, or between 400nm and 800nm.

9. The semiconductor device of any of claims 1 to 8, wherein a thickness (d2) of the intermediate layer (49) in the vertical direction (y) is between 200nm and 600nm.

10. The semiconductor device of any of claims 1 to 9, wherein a distance (d₃) between the source regions (31) and the intermediate layer (48) in the vertical direction (y) is between 300nm and 1000nm, or between 400nm and 800nm.

11. The semiconductor device of any of the preceding claims, wherein a ratio between the number of sensor cells (30s) and the number of transistor cells (30₁, 30₂) is between 1:10 and 1:40000.

12. The semiconductor device of any of the preceding claims, wherein
each of the plurality of transistor cells (30₁, 30₂) has a first length (lₐ) in a second horizontal direction (z), and a first width (s₁) in the first horizontal direction (x); and
each of the at least one sensor cell (30_{S}) has a second length (lₛ) in the second horizontal direction (z), and a second width (s₂) in the first horizontal direction (x), and wherein
the first length (lₐ) is at least three times the second length (lₛ), and
the first width (s₁) equals the second width (s₂).

## Patentansprüche

1. Halbleitervorrichtung, die Folgendes umfasst:
einen Halbleiter-Body (100), der eine erste Oberfläche (101), eine zweite Oberfläche (102), die der ersten Oberfläche (101) in einer vertikalen Richtung (y) gegenüberliegt, ein aktives Gebiet (220) und ein Sensorgebiet (230), das in einer ersten horizontalen Richtung (x) angrenzend an das aktive Gebiet (220) angeordnet ist, umfasst;
eine Mehrzahl von Transistorzellen (30₁, 30₂), die zumindest teilweise in das aktive Gebiet (220) integriert sind, wobei jede Transistorzelle (30₁, 30₂) ein Source-Gebiet (31), ein Body-Gebiet (32), ein Drift-Gebiet (35), das durch das Body-Gebiet (32) von dem Source-Gebiet (31) getrennt ist, und eine Gate-Elektrode (33) umfasst, die dielektrisch von dem Body-Gebiet (32) isoliert ist;
mindestens eine Sensorzelle (30_{S}), die zumindest teilweise in das Sensorgebiet (230) integriert ist, wobei jede der mindestens einen Sensorzelle (30_{S}) ein Source-Gebiet (31), ein Body-Gebiet (32), ein Drift-Gebiet (35), das durch das Body-Gebiet (32) von dem Source-Gebiet (31) getrennt ist, und eine Gate-Elektrode (33) umfasst, die dielektrisch von dem Body-Gebiet (32) isoliert ist;
eine Mehrzahl von ersten Kontaktstopfen (42₁);
eine Zwischenschicht (48); und
einen zweiten Kontaktstopfen (49), wobei
die Source-Gebiete (31) der Mehrzahl von Transistorzellen (30₁, 30₂) mit einer ersten Source-Elektrode (411) gekoppelt sind und die Source-Gebiete (31) der mindestens einen Sensorzelle (30_{S}) mit einer zweiten Source-Elektrode (412) gekoppelt sind, die von der ersten Source-Elektrode (411) getrennt und entfernt ist,
mindestens eine der Mehrzahl von Transistorzellen (30₁, 30₂) direkt an eine der mindestens einen Sensorzellen (30_{S}) angrenzt,
jeder der Mehrzahl von ersten Kontaktstopfen (42₁) sich zwischen einem der Source-Gebiete (31) der mindestens einen Sensorzelle (30_{S}) und der Zwischenschicht (48) erstreckt und eine elektrische Verbindung zwischen dem jeweiligen Source-Gebiet (31) und der Zwischenschicht (48) bereitstellt, und
sich der zweite Kontaktstopfen (49) zwischen der Zwischenschicht (48) und der zweiten Source-Elektrode (412) erstreckt und eine elektrische Verbindung zwischen der Zwischenschicht (48) und der zweiten Source-Elektrode (412) bereitstellt.

2. Halbleitervorrichtung nach Anspruch **1,** wobei
jede der Mehrzahl von Transistorzellen (30₁, 30₂) ferner ein Kompensationsgebiet (38) eines Dotierungstyps umfasst, der zu dem Dotierungstyp des Drift-Gebiets (35) komplementär ist und sich in der vertikalen Richtung (y) von einem jeweiligen Body-Gebiet (32) in das Drift-Gebiet (35) erstreckt; und
jede der mindestens einen Sensorzelle (30_{S}) ferner ein Kompensationsgebiet (38) eines Dotierungstyps umfasst, der zu dem Dotierungstyp des Drift-Gebiets (35) komplementär ist und sich in der vertikalen Richtung (y) von einem jeweiligen Body-Gebiet (32) in das Drift-Gebiet (35) erstreckt.

3. Halbleitervorrichtung nach Anspruch 1 oder 2, wobei die Gate-Elektroden (33) der Mehrzahl von Transistorzellen (30₁, 30₂) und die Gate-Elektroden (33) der mindestens einen Sensorzelle (30_{S}) mit einem gemeinsamen Gate-Pad (45) gekoppelt sind, und
die Drift-Gebiete (35) der Mehrzahl von Transistorzellen (30₁, 30₂) und die Drift-Gebiete (35) der mindestens einen Sensorzelle (30_{S}) mit einem gemeinsamen Drain-Gebiet (36) gekoppelt sind.

4. Halbleitervorrichtung nach einem der Ansprüche 1 bis 3, wobei die Mehrzahl von Transistorzellen (30₁, 30₂) Folgendes umfasst
eine Mehrzahl von ersten Transistorzellen (30₁), wobei jede der mindestens einen ersten Transistorzelle (30₁) zwei Source-Gebiete (31₁, 31₂) umfasst;
und mindestens eine, jedoch nicht mehr als zwei, zweite Transistorzellen (30₂), wobei jede der zweiten Transistorzellen (30₁) nur ein Source-Gebiet (31₁) umfasst, wobei
jede der zweiten Transistorzellen (30₂) direkt an eine der mindestens einen Sensorzellen (30_{S}) angrenzt und zwischen der mindestens einen Sensorzelle (30_{S}) und mindestens einer Teilmenge der Mehrzahl von Transistorzellen (30₁) angeordnet ist.

5. Halbleitervorrichtung nach einem der Ansprüche 1 bis 4, wobei die Zwischenschicht (48) Wolfram umfasst.

6. Halbleitervorrichtung nach einem der Ansprüche 1 bis 5, wobei
die Zwischenschicht (48) eine erste Teilschicht (48₁) und eine zweite Teilschicht (48₂) umfasst, die in der vertikalen Richtung (y) angrenzend an die erste Teilschicht (48₁) angeordnet sind; und
die erste Teilschicht (48₁) ein anderes Material als die zweite Teilschicht (48₂) umfasst.

7. Halbleitervorrichtung nach Anspruch 6,
wobei die erste Teilschicht (48₁) Wolfram umfasst und die zweite Teilschicht (48₂) Aluminium umfasst.

8. Halbleitervorrichtung nach einem der Ansprüche 1 bis 7, wobei ein Abstand (d₁) zwischen der Zwischenschicht (48) und der zweiten Source-Elektrode (412) in der vertikalen Richtung (y) zwischen 300 nm und 1000 nm oder zwischen 400 nm und 800 nm liegt.

9. Halbleitervorrichtung nach einem der Ansprüche 1 bis 8, wobei eine Dicke (d2) der Zwischenschicht (49) in der vertikalen Richtung (y) zwischen 200 nm und 600 nm liegt.

10. Halbleitervorrichtung nach einem der Ansprüche 1 bis 9, wobei ein Abstand (d₃) zwischen den Source-Gebieten (31) und der Zwischenschicht (48) in der vertikalen Richtung (y) zwischen 300 nm und 1000 nm oder zwischen 400 nm und 800 nm liegt.

11. Halbleitervorrichtung nach einem der vorhergehenden Ansprüche, wobei ein Verhältnis zwischen der Anzahl von Sensorzellen (30_{S}) und der Anzahl von Transistorzellen (30₁, 30₂) zwischen 1:10 und 1:40000 liegt.

12. Halbleitervorrichtung nach einem der vorhergehenden Ansprüche, wobei
jede der Mehrzahl von Transistorzellen (30₁, 30₂) eine erste Länge (lₐ) in einer zweiten horizontalen Richtung (z) und eine erste Breite (s₁) in der ersten horizontalen Richtung (x) aufweist; und
jede der mindestens einen Sensorzelle (30_{S}) eine zweite Länge (lₛ) in der zweiten horizontalen Richtung (z) und eine zweite Breite (s₂) in der ersten horizontalen Richtung (x) aufweist, und wobei
die erste Länge (lₐ) mindestens das Dreifache der zweiten Länge (lₛ) beträgt, und
die erste Breite (s₁) gleich der zweiten Breite (s₂) ist.

## Revendications

1. Un dispositif à semiconducteur, comprenant :
un corps (100) à semiconducteur comprenant une première surface (101), une deuxième surface (102) opposée à la première surface (101) dans une direction (y) verticale, une région (220) active et une région (230) de détecteur disposée de manière contiguë à la région (220) active dans une première direction (x) horizontale ;
une pluralité de cellules (30₁, 30₂) de transistor intégrées au moins en partie dans la région (220) active, chaque cellule (30₁, 30₂) de transistor comprenant une région (31) de source, une région (32) de corps, une région (35) de migration, séparée de la région (31) de source par la région (32) de corps, et une électrode (33) de grille isolée diélectriquement de la région (32) de corps ;
au moins une cellule (30_{S}) de détecteur intégrée au moins en partie dans la région (230) de détecteur, chacune de la au moins une cellule (30_{S}) de détecteur comprenant une région (31) de source, une région (32) de corps, une région (35) de migration, séparée de la région (31) de source par la région (32) de corps, et une électrode (33) de grille isolée diélectriquement de la région (32) de corps ;
une pluralité de premières fiches (42₁) de contact ;
une couche (48) intermédiaire ; et
une deuxième fiche (49) de contact, dans lequel
les régions (31) de source de la pluralité de cellules (30₁, 30₂) de transistor sont connectées à une première électrode (411) de source, et les régions (31) de source de la au moins une cellule (30_{S}) de détecteur sont connectées à une deuxième électrode (412) de source distincte et à distance de la première électrode (411) de source,
au moins l'une de la pluralité de cellules (30₁, 30₂) de transistor est adjointe directement à l'une des au moins une cellule (30_{S}) de détecteur,
chacune de la pluralité des premières fiches (42₁) de contact s'étend entre l'une des régions (31) de source de la au moins une cellule (30_{S}) de détecteur et la couche (48) intermédiaire et donne la connexion électrique entre la région (31) de source respective et la couche (48) intermédiaire et
la deuxième fiche (49) de contact s'étend entre la couche (48) intermédiaire et la deuxième électrode (412) de source et donne une connexion électrique entre la couche (48) intermédiaire et la deuxième électrode (412) de source.

2. Le dispositif à semiconducteur de la revendication 1, dans lequel
chacune de la pluralité de cellules (30₁, 30₂) de transistor comprend en outre une région (38) de compensation d'un type de dopage complémentaire du type de dopage de la région (35) de migration et s'étendant d'une région (32) de corps respective à la région (35) de migration dans la direction (y) verticale ; et
chacune de la au moins une cellule (30_{S}) de détecteur comprend en outre une région (38) de compensation d'un type de dopage complémentaire du type de dopage de la région (35) de migration et s'étendant d'une région (32) de corps respective à la région (35) de migration dans la direction (y) verticale.

3. Le dispositif à semiconducteur de la revendication 1 ou 2, dans lequel
les électrodes (33) de grille de la pluralité de cellules (30₁, 30₂) de transistor et les électrodes (33) de grille de la au moins une cellule (30_{S}) de détecteur sont connectées à une plage (45) commune de grille, et
les régions (35) de migration de la pluralité de cellules (30₁, 30₂) de transistor et les régions (35) de migration de la au moins une cellule (30_{S}) de détecteur sont connectées à une région (36) commune de drain.

4. Le dispositif à semiconducteur de l'une quelconque des revendications 1 à 3, dans lequel la pluralité de cellules (30₁, 30₂) de transistor comprend
une pluralité de premières cellules (30₁) de transistor, chacune de la au moins une première cellule (30₁) de transistor comprenant deux régions (31₁, 31₂) de source ;
et au moins une mais pas plus de deux deuxièmes cellules (30₂) de transistor, chacune des deuxièmes cellules (30₁) de transistor comprenant seulement une région (31₁) de source, dans lequel
chacune des deuxièmes cellules (30₂) de transistor est adjointe directement à l'une de la au moins une cellule (30_{S}) de détecteur et est montée entre la au moins une cellule (30_{S}) de détecteur et au moins un sous-ensemble de la pluralité de premières cellules (30₁) de transistor.

5. Le dispositif à semiconducteur de l'une quelconque des revendications 1 à 4, dans lequel la couche (48) intermédiaire comprend du tungstène.

6. Le dispositif à semiconducteur de l'une quelconque des revendications 1 à 5, dans lequel
la couche (48) intermédiaire comprend une première sous-couche (48₁) et une deuxième sous-couche (48₂) disposée de manière contiguë à la première sous-couche (48₁) dans la direction (y) verticale ; et
la première sous-couche (48₁) comprend un matériau différent de celui de la deuxième sous-couche (48₂).

7. Le dispositif à semiconducteur de la revendication 6, dans lequel la première sous-couche (48₁) comprend du tungstène et la deuxième sous-couche (48₂) comprend de l'aluminium.

8. Le dispositif à semiconducteur de l'une quelconque des revendications 1 à 7, dans lequel une distance (d₁) entre la couche (48) intermédiaire et la deuxième électrode (412) de source dans la direction (y) verticale est comprise entre 300 nm et 1 000 nm ou entre 400 nm et 800 nm.

9. Le dispositif à semiconducteur de l'une quelconque des revendications 1 à 8, dans lequel une épaisseur (d2) de la couche (49) intermédiaire dans la direction (y) verticale est comprise entre 200 nm et 600 nm.

10. Le dispositif à semiconducteur de l'une quelconque des revendications 1 à 9, dans lequel une distance (d₃) entre les régions (31) de source de la couche (48) intermédiaire dans la direction (y) verticale est comprise entre 300 nm et 1 000 nm ou entre 400 nm et 800 nm.

11. Le dispositif à semiconducteur de l'une quelconque des revendications précédentes, dans lequel un rapport entre le nombre de cellules (30_{S}) de détecteur et le nombre de cellules (30₁, 30₂) de transistor est compris entre 1:10 et 1:40000.

12. Le dispositif à semiconducteur de l'une quelconque des revendications précédentes, dans lequel
chacune de la pluralité de cellules (30₁, 30₂) de transistor a une première longueur (lₐ) dans une deuxième direction (z) horizontale et une première largeur (s₁) dans la première direction (x) horizontale ; et
chacune de la au moins une cellule (30_{S}) de détecteur a une deuxième longueur (lₛ) dans la deuxième direction (z) horizontale et une deuxième largeur (s₂) dans la première direction (x) horizontale et dans lequel
la première longueur (lₐ) est égale à au moins trois fois la deuxième longueur (lₛ), et
la première largeur (s₁) est égale à la deuxième largeur (s₂).
